# EUROPÄISCHE PATENTSCHRIFT

(11) **EP 3 757 826 B1**
(45) Veröffentlichungstag und Bekanntmachung des Hinweises auf die Patenterteilung: **25.12.2024**
(21) Anmeldenummer: 19183381.3
(22) Anmeldetag: 28.06.2019
(51) Int. Cl.: G01S 13/88, G01S 13/89

(54) **ANALYSEVERFAHREN FÜR DIE GEBÄUDEBEWIRTSCHAFTUNG**
ANALYSIS METHOD FOR BUILDING MANAGEMENT
PROCÉDÉ D'ANALYSE POUR LA GESTION DES IMMEUBLES

(43) Veröffentlichungstag der Anmeldung: 30.12.2020
(73) Patentinhaber: Aachener Grundvermögen Kapitalverwaltungsgesellschaft mbH, 50668 Köln (DE); Rheinisch-Westfälische Technische Hochschule (RWTH) Aachen, 52062 Aachen (DE)
(72) Erfinder: SCHMÜLLING, Christoph, 50354 Hürth (DE); BRELL-COKCAN, Sigrid, 52064 Aachen (DE); HAOWEI, Zhang, 52074 Aachen (DE); MARTENS, Jan, 52074 Aachen (DE); LUBLASSER, Elisa, 52064 Aachen (DE); BLANKENBACH, Jörg, 52379 Langerwehe (DE)
(74) Vertreter: Grünecker Patent- und Rechtsanwälte PartG mbB

(56) Entgegenhaltungen:
- CN-A- 108 731 736
- GB-A- 2 559 157
- US-A1- 2020 142 052
- TIAN JIN ET AL: "Image-Domain Estimation of Wall Parameters for Autofocusing of Through-the-Wall SAR Imagery", IEEE TRANSACTIONS ON GEOSCIENCE AND REMOTE SENSING, IEEE SERVICE CENTER, PISCATAWAY, NJ, US, vol. 51, no. 3, 1 March 2013 (2013-03-01), pages 1836 - 1843, XP011494849, ISSN: 0196-2892, DOI: 10.1109/TGRS.2012.2206395
- GONZALEZ-DRIGO R ET AL: "GPR survey applied to Modernista buildings in Barcelona: The cultural heritage of the College of Industrial Engineering", JOURNAL OF CULTURAL HERITAGE, EDITIONS SCIENTIFIQUES ET MEDICALES ELSEVIER, AMSTERDAM, NL, vol. 9, no. 2, 1 April 2008 (2008-04-01), pages 196 - 202, XP022689154, ISSN: 1296-2074, [retrieved on 20080529], DOI: 10.1016/J.CULHER.2007.10.006

## Beschreibung

Die vorliegende Erfindung betrifft ein Analyseverfahren für die Gebäudebewirtschaftung bzw. -verwaltung (Facility Management). Ein Analyseverfahren gemäß dem Oberbegriff von Anspruch 1 ist beispielsweise aus GB 2 559 157 A bekannt.

Die vorliegende Erfindung will eine Möglichkeit schaffen, möglichst detailliert die für die Bestandsaufnahme und Baudiagnose notwendigen Planungsgrundlagen zur Verfügung zu stellen.

Zur Lösung dieses Problems wird mit der vorliegenden Erfindung ein Analyseverfahren mit den Merkmalen von Anspruch 1 angegeben. Bei diesem Analyseverfahren werden Daten zum Aufbau von Bauteilen (z.B. Wänden, Decken, Stützen etc.) zusammen mit Grenzflächendaten der Bauteile erfasst, analysiert und für die Anzeige aufbereitet. Die Anzeige erfolgt dabei zumindest über einen Bildschirm. Das erfindungsgemäße Verfahren wird mit einem Prozessor durchgeführt, der zumindest eine Schnittstelle für die Eingabe der Grenzflächendaten und der Daten zum Aufbau aufweist. Die Grenzflächendaten sind dabei diejenigen Daten, die den den Raum begrenzenden Grenzflächen zugeordnet sind, also diese hinsichtlich ihrer räumlichen Ausdehnung definieren. Der Raum kann auch durch ein Bauteil begrenzt sein, dessen innerer Aufbau mit dem Verfahren analysiert wird. Soweit in der nachfolgenden Beschreibung auf den Raum begrenzenden Grenzflächen abgestellt wird, bedeutet dies damit auch, dass die Grenzflächen eines spezifischen Bauteils innerhalb des Wandaufbaus oder ein in dem Raum freistehendes Bauteil gemeint sein kann. Bei einem Querschnitt auf Bodenniveau geben diese Daten den visuell wahrgenommenen Grundriss an. Die Daten zum Aufbau geben Details im Innern einer oder mehrerer dieser Grenzflächen an, beispielsweise die Dicke der aufeinanderfolgenden Schichten, etwaige in Wandflächen oder Böden vorhandener konstruktiver Elemente oder Komponenten wie Tragwerk, Dämmung, Verkleidung und/oder Leitungen, also Details zum inneren Aufbau hinter den Grenzflächen.

Bei dem erfindungsgemäßen Verfahren werden beide Datensätze, nämlich der Datensatz zum Aufbau und der Datensatz, der die optisch wahrnehmbare Grenzfläche des Raumes bzw. eines Bauteils spezifiziert, einander zugeordnet, sodass eine räumliche Aufteilung der Daten zum Aufbau über die Abmessung der Grenzfläche möglich ist. Das erfindungsgemäße Verfahren verwirklicht sich bereits bei der Zuordnung von Daten zum Aufbau zu einer einzigen Wand- oder Bodenfläche bzw. Bauteiloberfläche. Vorzugsweise werden sämtliche Grenzflächen durch das erfindungsgemäße Verfahren in der zuvor definierten Weise spezifiziert, wobei die Spezifikation in einem Speicher abgelegt und üblicherweise für die Anzeige aufbereitet wird.

Die vorliegende Erfindung bietet dementsprechend die Möglichkeit einer automatisierten, digitalen Bestandsaufnahme und Baudiagnose, die nicht nur die sichtbaren Grenzflächen, d. h. die Oberflächen der bzw. Bauteiloberfläche in Betracht zieht, sondern auch den dahinterliegenden Aufbau und damit die Struktur, Qualität und Festigkeit bzw. Tragfestigkeit der Wand und damit des den Raum umgebenden Gebäudes. Das erfindungsgemäße Verfahren ist ein in der Regel computergestütztes durchgeführtes Verfahren. Die Decke und der Boden eines Raumes sind auch als Wand im Sinne der Erfindung anzusehen.

Dabei will die vorliegende Erfindung insbesondere die detaillierte Erfassung im Bestand erleichtern. Hierzu werden die Grenzflächendaten üblicherweise mit einem bild- und/oder lasergestützten Verfahren (z.B. RGB-Kamera, Laserscanner) erfasst und in dem Speicher abgelegt und den Daten zum Aufbau diesen Grenzflächendaten zugeordnet. Dabei will die vorliegende Erfindung insbesondere Daten bereitstellen, auch eine digitale Bearbeitung in einem 3D Modell, insbesondere in einer BIM (Building Information Modeling) Datenstruktur erlauben. Die durch das Verfahren erzeugten Daten zum inneren Aufbau werden bevorzugt in einem BIM-Format ausgegeben und in einer BIM-Software angezeigt bzw. zur Anzeige weiterverarbeitet. Diese Verfahrensführung lässt sich von der Überlegung leiten, dass idealerweise in einem einheitlichen Analyseverfahren bevorzugt die Grenzflächendaten zusammen mit den Daten zum Aufbau ermittelt werden, was die räumliche (und zeitliche) Referenzierung der beiden Datensätze vereinfacht und dementsprechend eine konsistente und automatisierte Zuordnung der Daten zum Aufbau zu den Grenzflächendaten ermöglicht. Dazu können beispielsweise im Rahmen der Datenerfassung Referenzpunkte auf die Grenzfläche ausbildende Wand-, Decken- oder Bodenfläche projiziert werden, die auch beim Erfassen der Daten zum Aufbau erfasst und als Referenzpunkt herangezogen werden, um beide Messungen in einem einheitlichen Koordinatensystem zu referenzieren. Das Vermessen der sichtbaren Flächen und/oder das Erfassen der Referenzpunkte erfolgt bevorzugt durch Laser - und/oder Bildmesstechnik. Die hierbei gewonnenen Daten werden dem Aufbau zugeordnet und können in einer einheitlichen, räumlich auflösenden Darstellung der Wand und deren Aufbau ausgegeben werden.

Mit dem erfindungsgemäßen Verfahren ist es möglich, eine Art Schnittansicht der jeweiligen Wand zu erstellen, die zumindest eine visuelle Analyse des Bestandes auch hinter der sichtbaren Oberfläche ermöglicht. Nicht selten sind beispielsweise die den Raum begrenzenden Wandflächen vorgesetzte Wandflächen beispielsweise eines Mobiliars oder einer Verkofferung bzw. Ergebnis einer Umgestaltung des Raumes. Die den Raum begrenzenden Grenzflächen müssen daher nicht notwendigerweise diejenigen Grenzflächen sein, die konstruktiv bedingt den Raum begrenzen. Auf diese Flächen kommt es aber in der Regel an, wenn im Bestand geplant wird, um beispielsweise ein neues gestalterisches Konzept für einen Raum in einer Bestandsimmobilie zu erarbeiten oder die wahre Nettogeschoss-Fläche zu ermitteln.

Die vorliegende Erfindung bedient sich dabei der "zerstörungsfreien Werkstoffprüfung". Die den Aufbau wiedergebenden Daten werden durch ein zerstörungsfreies Verfahren gewonnen, basierend auf elektromagnetische Wellen in einem Frequenzspektrum zwischen 100 MHz und 15 GHz, deren Reflexionssignal dazu verwendet wird, auf den inneren Aufbau des Bauteils zu schließen. Die vorliegende Erfindung ist daher als Ultrabreitbandradar (UWB) mit einer niedrigen Signalstärke zu betrachten, die den lokalen Funk nicht beeinträchtigt.

Der vorliegenden Erfindung geht es insbesondere darum, den Aufbau möglichst detailliert und hinsichtlich seiner Eigenschaften und/oder stofflichen Beschaffenheit genauer zu spezifizieren, und zwar zumindest teilautomatisiert, mit geringem manuellen Eingriff. Die Bedienung der Hardware für die Datenerfassung der Grenzflächen und der Aufbau kann dabei durch manuelle Führung erfolgen, während die Datenauswertung der Grenzflächen und der Aufbau mittels Algorithmen zumindest teilautomatisiert analysiert und interpretiert werden. Dies bringt es mit sich, dass die lückenlose Analyse des Aufbaus eines Bauteils eine erhebliche Datenerfassung erfordert. Mit Blick darauf wird gemäß einer bevorzugten Weiterbildung der vorliegenden Erfindung vorgeschlagen, dass die Daten zum Aufbau durch Radarmessungen an diskreten Stellen der Bauteiloberfläche erzeugt werden. Diese diskreten Stellen haben üblicherweise einen erheblichen Querabstand. Es versteht sich, dass dieser Querabstand in horizontaler und/oder in vertikaler Richtung vorgesehen sein kann. Üblicherweise wird auf die zu vermessende Grenzfläche ein Raster gelegt oder projiziert, an dessen Rasterpunkten jeweils eine Analyse der Fläche im Hinblick auf ihren inneren Aufbau durchgeführt wird.

Üblicherweise wird auf die zu vermessende Grenzfläche ein Referenzpunkt mit einer Erfassungsrichtung (Horizontal oder Vertikal) gelegt oder projiziert, an dessen Referenzpunkt eine Analyse der Querschnittsfläche im Hinblick auf ihren inneren Aufbau durchgeführt wird. Diese lineare Erfassung, mit den Start am Referenzpunkt, kann beliebige Länge aufweisen. Dabei stellt eine längere Distanz mehr Informationen zur Auswertung zur Verfügung, jedoch sollte die Länge nicht weniger als 50 cm betragen, da es sonst zu einer fehlerhaften Datenauswertung kommen kann.

Dieser lineare Aufnahmepfad wird bevorzugt mit einem der Grenzfläche konkret zugeordneten Referenzpunkt abgespeichert, so dass mit den Lageinformationen der einzelnen Aufnahmepfade beim Ermitteln der Daten zum Aufbau an diesen spezifischen Referenzpunkten die Lage des Messpunktes relativ zu der Grenzfläche und unter Berücksichtigung bzw. in Kenntnis des Referenzpunktes bestimmt ist. Dabei können die Lageinformationen zu dem einzelnen Messpunkt, beispielsweise referenziert auf den Pfad, händisch eingegeben werden. Ebenso ist es möglich, den Messpunkt durch Bestimmen der Position des Messgerätes zum Ermitteln der Daten zum Aufbau automatisiert zu erfassen und zu dem jeweiligen Messpunkt abzuspeichern. Dabei lässt sich die vorliegende Erfindung von der Überlegung leiten, dass ein die elektromagnetischen Wellen aussendendes Messgerät verhältnismäßig nahe an die Oberfläche der Fläche verbracht wird, um deren Aufbau zu analysieren. Bei der zuvor beschriebenen Variante wird das Messgerät üblicherweise händisch auf die jeweiligen Referenzpunkte aufgesetzt, um dort jeweils Daten zum Aufbau zu generieren. Ebenso gut ist es indes möglich, das Messgerät zum Aussenden der Radarstrahlen durch einen Manipulator üblicherweise parallel zur Grenzfläche des zu vermessenden Bauteils zu verfahren und die Bewegungsdaten des Manipulators zu nutzen, um die Lage des Messgerätes relativ zu der Bauteiloberfläche zu bestimmen. So können auch die Lageinformationen zu dem jeweiligen Messpunkt für die Erfassung der Daten zum Aufbau automatisiert generiert und abgespeichert werden.

Ein Führen des Messgerätes ohne Berührung der Grenzfläche ist ebenso möglich. Die Bewegungen des Manipulators könnten dabei sowohl anhand der durch Lasermessung- und/oder Bildgebung erfassten Grenzflächen als auch a priori existierenden Plandaten programmiert werden. Dies kann teilautomatisiert und in weiterer Ausgestaltung automatisiert erfolgen. Je nach Aufbau des Manipulators kann auch die Vorrichtung für die Erfassung der Grenzflächen durch den Manipulator geführt werden. Es kann eine automatisierte Übertragung der Grenzflächeninformationen an Prozessoren des Manipulators zur Verarbeitung und Bahnplanung für die Bauteilaufbaumessung erfolgen.

Bei dem erfindungsgemäßen Verfahren finden die Daten zum Aufbau Eingang in die Bewegungssteuerung des Manipulators oder Roboters. So kann beispielsweise das Messgerät relativ zügig parallel relativ zu der Oberfläche bewegt werden, bis eine Unstetigkeit im Aufbau erkannt wird. Zur genaueren Analyse dieser Unstetigkeit kann in dem Bereich eine hohe Datendichte z.B. durch Verlangsamen der Geschwindigkeit erzeugt werden. Auch kann das Messgerät entgegen der ursprünglichen Bewegung bewegt werden, um den exakten Punkt der Unstetigkeit geometrisch aufzulösen und zu hinterlegen.

Bei dem erfindungsgemäßen Verfahren werden bevorzugt auf Basis eines Reflexionsmusters der reflektierten Welle Schichten ermittelt, die hinter der Fläche liegen. Bei dieser bevorzugten Weiterbildung geht es vor allem darum, die Dicke der einzelnen Schichten zu ermitteln und deren orthogonalen Abstand relativ zu der Grenzfläche zu erfassen. Diese Messung erfolgt dabei durch das Reflexionsmuster. Insbesondere durch die Permittivität der Materialien können diese Schichten durch das Reflexionsmuster voneinander unterschieden werden. Durch das Reflexionsmuster kann nicht nur die Lage und demnach die Dicke der einzelnen Schichten ermittelt werden. Vielmehr ist es auch möglich, Rückschlüsse auf die stoffliche Beschaffenheit zu ziehen.

Trockenes Mauerwerk hat beispielsweise eine Permittivität bei einer Frequenz von 1 GHz von 3 bis 5ε, wohingegen feuchtes Mauerwerk eine Permittivität 5 bis 26ε hat. Die Permittivität von trockenem Beton liegt bei 6 bis 8ε, wohingegen feuchter Beton eine Permittivität von 8 bis 16ε hat.

Die spezifischen Permittivitäten der zu vermessenen Materialien ändern sich auch mit äußeren Zustandsgrößen wie beispielsweise Feuchtigkeit oder Temperatur. So kann es für eine Kalibrierung notwendig sein, tatsächlich ein vorangehendes Verfahren zur Ermittlung des Bauteilzustands wie Feuchtigkeit oder Temperatur durchzuführen.

Die Verarbeitung der gewonnenen Daten zum Aufbau erfolgt üblicherweise durch Laufzeitmessung, der auf die Grenzfläche aufgebrachten Wellen in dem Aufbau. Die Analyse der Materialeigenschaften erfolgt dabei üblicherweise durch eine Signalverarbeitung, die die Laufzeitmessung in eine Frequenzmessung umwandelt. Ausgehend von dieser Frequenzmessung erfolgt danach die Zuordnung spezifischer Stoffe zu dem ermittelten Reflexionsmuster. Durch die materialspezifische Primitivität gibt es eine Frequenzänderung der Reflexionsmuster. Durch die kombinierte Verarbeitung der Laufzeit (Messung der Schichten hinsichtlich der Dicke) und der Frequenzänderung, lassen sich unterschiedliche Frequenzunterschiede im Aufbau feststellen. Das entsprechende Verhalten wird vorzugsweise in einem Speicher hinterlegt, um diese Daten mit Daten einer sogenannten Materialbibliothek zu vergleichen und aufgrund dieses Vergleichs auf die stoffliche Beschaffenheit der jeweiligen Schicht zu schließen. Die sogenannte Materialbibliothek ist dabei auf einem Speicher hinterlegt und gibt Reflexionsdaten zu dem Reflexionsverhalten bestimmter Baumaterialien wieder. Wird dieses Verhalten innerhalb der gemessenen Daten erkannt, wird der jeweiligen Schicht die stoffliche Beschaffenheit zugeordnet. Die Darstellung der entsprechenden Schicht kann dann zusammen mit der Materialinformation erfolgen, wobei zum Beispiel einzelnen Materialien in der Schnittdarstellung der Wand spezifische Farben zugeordnet sind.

Sofern dieser Vergleich zu keiner Übereinstimmung führt und sich dementsprechend aufgrund des Reflexionsmuster keine stoffliche Beschaffenheit einer spezifischen Schicht bestimmen lässt, kann wahlweise das nicht zuordenbare Baumaterial einer Schicht in eine Eigenschaftsklasse zugeordnet werden, die zumindest in allgemeiner Form Informationen zur Qualität der Schicht aufgrund des Reflexionsmusters wiedergibt. Solche Eigenschaftsklassen können beispielsweise angeben, ob es sich um ein Material hoher oder geringer Dichte und damit um ein tragendes bzw. tragfähiges oder nicht tragfähiges Material handelt. Der die Materialbibliothek enthaltende Speicher ist dabei überschreibbar, so dass später aufgefundene Erkenntnisse zu spezifischen Baumaterialien und deren Reflexionsmuster bzw. Permittivität in den Speicher eingeschrieben werden können.

Bevorzugt wird mit den gewonnenen Grenzflächendaten eine Kalibrierung des Reflexionsmusters durchgeführt. Die Grenzflächendaten geben üblicherweise auch die Stärke von Wänden oder Elementen innerhalb des Gebäudes an. Diese bekannten Abmessungen werden bei der bevorzugten Weiterbildung der Erfindung zur Kalibrierung des Reflexionsmusters genutzt. Demzufolge gibt das Reflexionsmuster nach der Kalibrierung mit höherer Genauigkeit die tatsächlichen geometrischen Verhältnisse innerhalb der Wand wieder und lässt insbesondere eine exakte Bestimmungen des Abstandes der einzelnen Grenzflächen des inneren Aufbaus von der außen sichtbaren Oberfläche zu.

Das Analyseverfahren eröffnet alternativ oder ergänzend auch die Möglichkeit, bei einem nicht einem spezifischen Stoff zuzuordnenden Baumaterial zu dem jeweiligen Reflexionsmuster einen Eingabewert zu hinterlegen. Dieser Eingabewert kann auch die spezifische Benennung des Baumaterials sein. Alternativ können Merkmale zu der oben genannten Eigenschaftsklasse hinterlegt werden. Das entsprechende Fenster öffnet sich üblicherweise automatisiert in der Anzeige beim Aufbereiten und Ablegen der Messdaten zu den jeweiligen Ortsinformationen in Bezug auf die den Raum begrenzenden Flächen ab, wenn das Material der entsprechenden Schicht nicht automatisch aufgrund des Reflexionsmusters identifiziert werden konnte. Über dieses Fenster kann auch die durch Probennahme ermittelte Benennung und/oder Charakterisierung des Materials eingegeben werden.

Nach einer bevorzugten Weiterbildung der vorliegenden Erfindung lässt sich in einem das Verfahren durchführenden Computersoftware in einer Anzeigeeinrichtung ein Eingabefenster öffnen, welches die Eingabe eines von der Außenseite der Grenzfläche bestimmbaren Eigenschaftswertes erlaubt. Dabei kann ein Prozessor zur Durchführung des erfindungsgemäßen Analyseverfahrens eine Vorauswahl zur Verfügung stellen, die verschiedene Eigenschaftswerte anzeigt, von denen zumindest eines auszuwählen ist. Von außen bestimmbare Eigenschaftswerte sind beispielsweise die Feuchtigkeit und/oder die Rissigkeit einer Oberfläche.

Gemäß einer weiteren bevorzugten Ausgestaltung der vorliegenden Erfindung werden die Grenzflächendaten analysiert, um ebene Grenzflächenabschnitte, der den Raum begrenzenden Flächen zu definieren und einzelne zugehörige Grenzflächendaten diesen Grenzflächenabschnitten zuzuordnen. Dabei werden bevorzugt innerhalb einer die Grenzfläche abbildenden Punktewolke Kanten definiert, zwischen denen sich der idealisiert vollkommen ebene Flächenabschnitt erstreckt. Die Weiterbildung lässt sich von der Überlegung leiten, dass Wände in Räumen üblicherweise eben oder zumindest näherungsweise eben sind. Sie will aus punktuellen Informationen in einem regelmäßigen oder unregelmäßigen Raster zur Lage und Form der Grenzfläche vektorisierte Informationen machen, die eine Vielzahl von Grenzflächendaten in sich aufnehmen, wodurch die Verarbeitung der Lage- und Forminformationen zu den einzelnen Flächen vereinfacht wird.

Das erfindungsgemäße Verfahren wird bevorzugt in einer Analysesoftware und im Wesentlichen teilautomatisiert durchgeführt. Hierzu wird eine Analysesoftware/ein Analyseprogramm für die Bauwerksbewirtschaftung vorgeschlagen, die/das insbesondere durch ein laser- und/oder bildbasiertes Verfahren ermittelte Grenzflächendaten zu einen Raum begrenzenden Flächen zusammen mit Daten zum Aufbau in einem Speicher abgelegt und zur Anzeige zumindest einer der Flächen mit dem dahinterliegenden Aufbau aufbereitet.

Gemäß einer weiteren bevorzugten Ausgestaltung der vorliegenden Erfindung werden die entstanden Daten (z.B. Grenzflächen, Aufbau, Analyseergebnisse, Vektorisierung) in der Analysesoffiniare gemäß Datenstandards so gewandelt und formatiert, dass eine Importierung in anderen Datenverarbeitungsprogrammen der Gebäudewirtschaft, Bauplanung und Architektur ermöglicht wird. Die Daten werden bevorzugt in einem BIM-Format ausgegeben.

Weitere Einzelheiten und Vorteile der vorliegenden Erfindung ergeben sich aus der nachfolgenden Beschreibung eines Ausführungsbeispiels in Verbindung mit der Zeichnung. In dieser zeigen:
Figur 1: ein Beispiel eines grundsätzlichen Aufbaus zur Durchführung des Verfahrens;
Figur 2 ein Schaubild zur Verdeutlichung der wesentlichen Verfahrensschritte des Verfahrens und
Figur 3 ein Flussdiagramm zur Verdeutlichung der Systematik des Verfahrens.

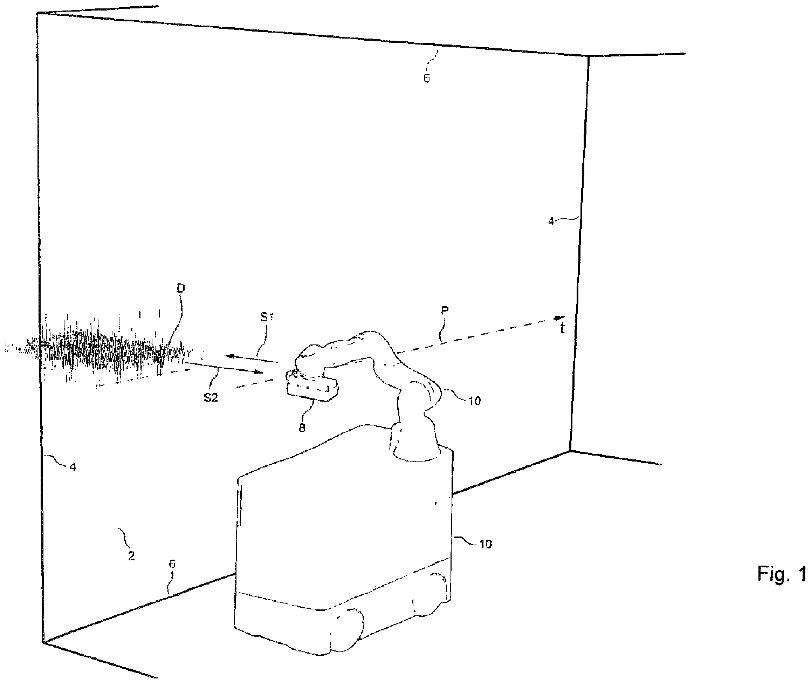

Die Figur 1 zeigt schematisch einen Aufbau zur automatisierten Durchführung des Verfahrens. Eine Wand 2 ist zwischen seitlichen vertikalen Kanten 4 und oberen bzw. unteren horizontalen Kanten 6 definiert. Der innere Aufbau der Wand 2 soll mit dem Analyseverfahren analysiert werden. Dazu wird ein Radargerät 8 über einen Manipulator 10 in horizontaler Richtung und mit Abstand der Wand 2 bewegt. An diskreten Messpunkten wird mit Abstand zu der Wand 2 von dem Radargerät 8 ein ausgehendes Signal S1 abgesetzt, welches im Inneren der Wand 2 abhängig von den stofflichen Eigenschaften des die Wand bildenden Aufbaus reflektiert und als eingehendes Signal S2 erfasst wird. Das über den Aufnahmepfad P empfangene Signal ist in dem Diagramm D beispielhaft gezeigt.

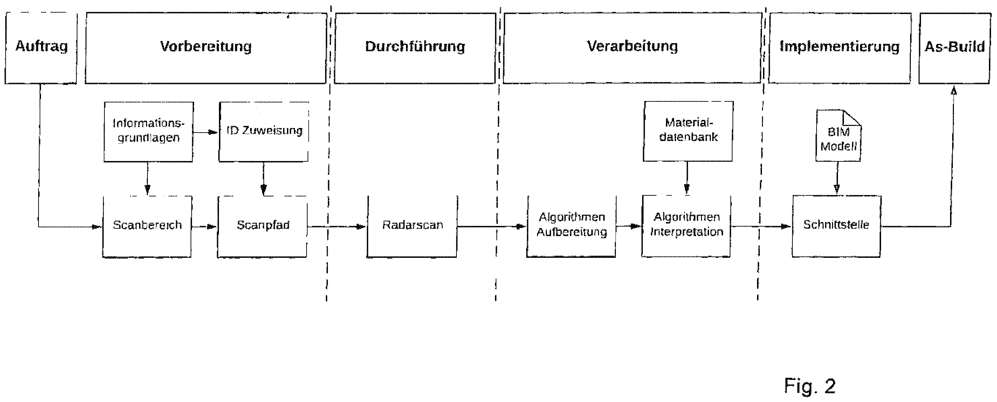

Unter Bezugnahme auf Figur 2 wird nachstehend ein denkbarer Ablauf eines erfindungsgemäßen Verfahrens anhand eines Ausführungsbeispiels verdeutlicht.

Zur Vorbereitung der Verfahrensdurchführung wird ein Aufnahmebereich definiert, der mehrere Flächen oder lediglich einen Teilabschnitt einer einzelnen Fläche umfassen kann. Bei dem Beispiel der Figur 1 ist dieser Aufnahmebereich durch die Fläche der Wand 2 gebildet.

Innerhalb dieses Aufnahmebereichs wird ein Aufnahmepfad P definiert.

Im Rahmen der Verfahrensdurchführung wird das Gerät zur Ermittlung der Daten zum Aufbau, d. h. der Radar Scanner über den Aufnahmepfad geführt, um abhängig von den Lageinformationen des Pfades Informationen zum Aufbau an vorbestimmten Positionen zu ermitteln.

Die bei der Aufnahme erfassten Daten zum Aufbau werden über Softwarealgorithmen aufbereitet, um die Lage von einzelnen hinter der Fläche liegenden Schichten und/oder deren Eigenschaften und/oder deren stoffliche Beschaffenheit zu ermitteln. Diese Analyse erfolgt einerseits aufgrund des Reflexionsmusters gegebenenfalls bei variierend abgestrahlten Wellenlängen und gegebenenfalls bei Abgleich der aufbereiteten Daten mit Daten zur stofflichen Beschaffenheit aus der Materialbibliothek. Andererseits werden Informationen, die sich aus der Oberflächenerfassung ergeben, z.B. die Abstände und Schnittwinkel der Grenzflächen eines Bauteils, genutzt, um eine sichere Detektion der Grenzflächen in den Radardaten zu ermöglichen sowie eine geometrische Kalibrierung der Radardaten vorzunehmen und damit insgesamt die voll- oder teilautomatisierte Vorauswertung der Radardaten zu ermöglichen. Ergänzend kann nach Anzeige der aufbereiteten Daten an einem Bildschirm noch durch einen Benutzer eine visuelle Interpretation vorgenommen und durch händische Eingabe die Analyse ergänzt werden, um an einzelnen oder mehreren Messpunkten des Aufnahmepfades einzelne oder mehrere Schichten einer Eigenschaftsklasse zuzuordnen oder zu der entsprechenden Schicht einen Eingabewert zu hinterlegen, der auch für nachfolgende Datenanalysen als Referenzwert für ein bestimmtes Material bzw. eine bestimmte Materialeigenschaft in die Materialbibliothek eingetragen werden kann.

Die so gewonnenen Daten können digital gespeichert und nach Bedarf über eine Softwareschnittstelle zur weiteren Verarbeitung oder zu Archivierungszwecken abgegeben werden.

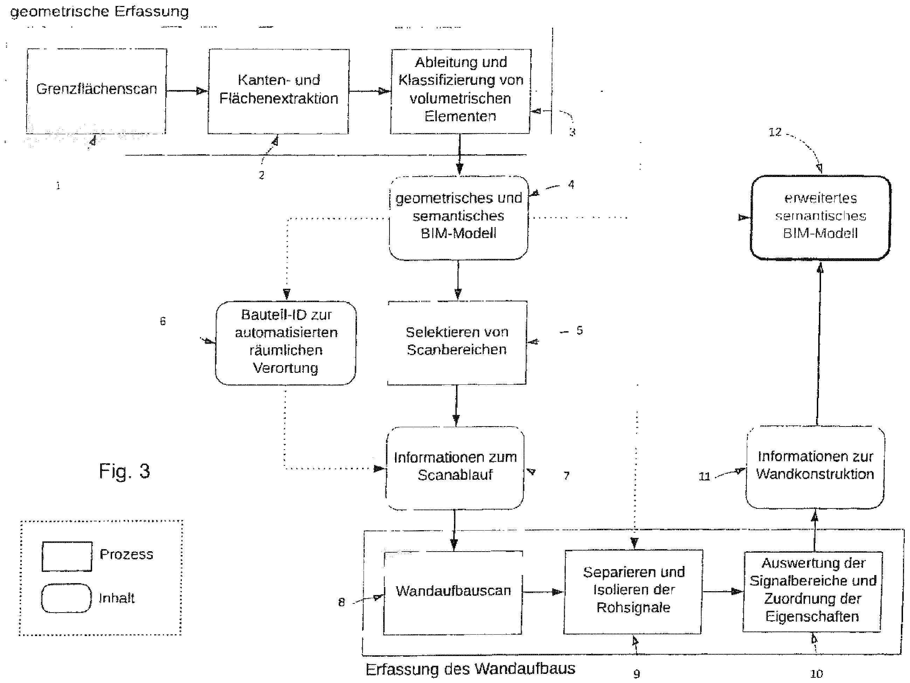

Die Figur 3 vermittelt ein Flussdiagramm zur Verdeutlichung der Verfahrensdurchführung. Zunächst wird im Schritt 1 ein Oberflächenscan erzeugt. Dieser erfasst bei dem Ausführungsbeispiel nach Figur 1 sämtliche Oberflächenbereiche des dort beispielhaft gezeigten Raumes und hinterlegt dessen Oberflächen datenmäßig als Datenpunkte.

Diese Datenpunkte werden bearbeitet, um Flächen und Kanten der Wandflächen und gegebenenfalls Flächen eines Objektes innerhalb des Raumes zu definieren; Schritt 2. Zur Vereinfachung der datenmäßigen Darstellung einzelner Flächen oder Flächenabschnitte können diese auch in Schritt 2 in Form von Vektoren zwischen Datenpunkten definiert werden.

Im Schritt 3 erfolgt eine Klassifizierung im Sinne einer Benennung der Objekte bzw. Flächen des Raumes. So werden einzelne Flächen als Decken, Boden, Seitenwände oder Objekte wie Säule oder Sockel benannt. Auch können zu einzelnen, in der Wand vermuteten Elementen Informationen zu deren Dicke bzw. zur stofflichen Beschaffenheit hinterlegt werden oder die von außen zu messende Dicke der Wand selbst.

Durch diese Ableitung unter Schritt 3 erhält man als Inhalt (Schritt 4) ein durch die Schritte 1 und 2 erhaltenes geometrisches Modell, welches durch die Behandlung und Ergänzung unter Schritt 3 um semantische Information ergänzt ist. Das Modell ist ein BIM-Modell und kann in einem entsprechenden, mit einer BIM-Software (z.B. Autodesk REVIT oder ARCHICAD) verarbeitbaren Format abgelegt werden. Die Zuordnung erfolgt dabei bevorzugt automatisiert beispielsweise durch Verknüpfen der geometrischen Daten mit Daten eines Beschleunigungssensors, der die Orientierung eines Scanners, der in Schritt 1 wirksam ist, im Betrieb des Scanners erfasst. Mit diesen Daten zur Orientierung und der allgemeinen Anschauung zum Vorhandensein von Wand- bzw. Decken- und Bodenflächen werden diese automatisch identifiziert und entsprechend benannt bzw. die von Ihnen vorspringenden oder sich zwischen diesen erstreckenden Elemente benannt.

Aus diesem BIM-Modell werden in Schritt 6 erkannte Strukturen referenziert, sodass im Weiteren eine Bezugnahme in der Software auf die entsprechenden Strukturen erfolgen kann. Die Referenzierung erfolgt mit der Terminologie der BIM-Software.

Im Schritt 5 wird durch den Benutzer ein Bereich als Scanbereich ausgewählt, in dem die hinter der Grenzfläche liegende Struktur und danach der strukturelle Aufbau hinter der Grenzfläche aufgeklärt werden soll. Daraus ergeben sich im Schritt 7 Informationen zum Scanablauf, die zur Stellung des Manipulators 10 genutzt werden kann, um das Radargerät 8 parallel zu der Wand und mit Abstand dazu zu führen.

An den dadurch vorgegebenen Referenzpunkten oder Aufnahmepfaden wird das Signal S1 des Radargerätes 8 ausgestrahlt und das Signal S2 empfangen; Schritt 8. im Schritt 9 werden die so erhaltenen Rohsignale bearbeitet. So kann mit den in Schritt 3 eingegebenen Informationen zu den Elementen die räumliche Auflösung in der Tiefe verbessert bzw. kalibriert werden, wenn ein Element hinter der Grenzfläche erkannt und mit seiner Dicke im Schritt 3 hinterlegt worden ist. Bei Fehlen solcher Erkenntnisse kann mittels eines Algorithmus die Kalibrierung beispielsweise über die in Schritt 1 gemessene Dicke der baulichen Struktur erfolgen, auf dessen Grenzflächen die ausgehenden Signale des Radargeräts auftreffen.

Im Schritt 10 wird ein Algorithmus durchlaufen, bei dem auf Basis des Reflexionsmusters der eingehenden Signale S2 der Aufbau der Wand wird, insbesondere Phasengrenzen zwischen einzelnen Schichten oder Elementen innerhalb der Wand definiert werden. Mit der materialspezifischen Änderungen der Frequenz dieser Signale S2 wird auch die stoffliche Beschaffenheit der ermittelten Struktur hinter der Grenzfläche erkannt. Als Ergebnis ergeben sich in Schritt 11 Informationen zur Konstruktion der Wand, deren tragende Elemente sowie in der Wand verbaute Elemente wie Rohre, elektrische Leitungen und dergleichen.

Diese Informationen werden in Schritt 12 auf das BIM-Modell zurückgeführt. Es wird dementsprechend ein BIM-Modell als 3D-Modell erhalten, welches nicht nur die Lage der von außen sichtbaren Grenzflächen vorgibt, sondern auch Informationen über die dahinterliegende Struktur und den Aufbau der Wand bzw. Decke, bzw. des Bodens enthält und visualisiert. Die Identifizierung der jeweiligen Flächen erfolgt aufgrund der in Schritt 6 zugewiesenen ID.

## Patentansprüche

1. Analyseverfahren für die Gebäudebewirtschaftung bzw. -verwaltung, bei dem Grenzflächendaten zu einen Raum begrenzenden Grenzflächen zusammen mit Daten zum Aufbau, die durch Aufbringen von elektromagnetischen Wellen auf die Grenzfläche und Empfangen der reflektierten Wellen ermittelt werden, in einem Speicher abgelegt und für die Anzeige aufbereitet werden, wobei die Grenzflächendaten die den Raum begrenzenden Grenzflächen hinsichtlich ihrer räumlichen Ausdehnung definieren und die Daten zum Aufbau Details zum inneren Aufbau hinter der Grenzfläche angeben, **dadurch gekennzeichnet, dass** die Bewegungen eines Radarwellen auf die Grenzfläche aufbringenden Messgerätes auf Basis der Daten zum Aufbau so gesteuert werden, dass bei Erkennen einer Unstetigkeit im Aufbau eine Datendichte im Bereich der Unstetigkeit durch Verlangsamen der Bewegungen des Messgeräts erhöht wird.

2. Analyseverfahren nach Anspruch 1 **dadurch gekennzeichnet, dass** die Grenzflächendaten durch ein Bildgebungs- und/oder Lasermessverfahren gewonnen werden.

3. Analyseverfahren nach einem der vorherigen Ansprüche, **dadurch gekennzeichnet, dass** an diskreten Stellen der Grenzfläche durch Aufbringen von Radarwellen auf die Grenzflächen und Empfangen der reflektierten Wellen die Daten zum Aufbau ermittelt und zugeordnet zu Lagedaten der diskreten Stellen der Grenzfläche abgespeichert werden.

4. Analyseverfahren nach einem der vorherigen Ansprüche, **dadurch gekennzeichnet, dass** auf Basis eines Reflexionsmusters der reflektierten Wellen die Lage und Abmessung von hinter der Grenzfläche liegenden Schichten ermittelt wird.

5. Analyseverfahren nach Anspruch 4, **gekennzeichnet durch eine** geometrische Kalibrierung des Reflexionsmusters auf Basis von Grenzflächendaten.

6. Analyseverfahren nach einem der vorherigen Ansprüche, **dadurch gekennzeichnet, dass** zur Analyse der hinter der Grenzfläche liegenden Materialien die Frequenz der auf die Grenzfläche abgestrahlten Wellen variiert wird.

7. Analyseverfahren nach Anspruch 6, **dadurch gekennzeichnet, dass** aufgrund der materialabhängigen Permittivität auf die stoffliche Beschaffenheit von Schichten hinter der Grenzfläche geschlossen wird.

8. Analyseverfahren nach Anspruch 7, **dadurch gekennzeichnet, dass** die Daten zu dem Reflexionsmuster mit gespeicherten Reflexionsdaten zu dem Reflexionsverhalten bestimmter Baumaterialien verglichen werden, um auf die stoffliche Beschaffenheit einer der Schichten hinter der Grenzfläche zu schließen, und dass der Schicht ein spezifisches Baumaterial zugeordnet wird.

9. Analyseverfahren nach Anspruch 8, **dadurch gekennzeichnet, dass** sofern der Vergleich zu keiner Übereinstimmung führt, wahlweise das nicht zuordenbare Baumaterial einer Schicht in eine Eigenschaftsklasse einklassifiziert und/oder zu der stofflich nicht bestimmbaren Schicht in einer Anzeigeeinrichtung einer das Verfahren durchführenden Datenverarbeitungseinrichtung ein Eingabefenster geöffnet wird, welches die Eingabe eines Eingabewertes zu der entsprechenden Schicht erlaubt.

10. Analyseverfahren nach einem der vorherigen Ansprüche, **dadurch gekennzeichnet, dass** in einer Anzeigeeinrichtung einer das Verfahren durchführenden Datenverarbeitungseinrichtung ein Eingabefenster geöffnet wird, welches die Eingabe eines von der Außenseite der Grenzfläche bestimmbaren Eigenschaftswertes erlaubt.

11. Analyseverfahren nach einem der vorherigen Ansprüche, **dadurch gekennzeichnet, dass** die Grenzflächendaten analysiert werden, um ebene Flächenabschnitte der den Raum begrenzenden Grenzflächen zu identifizieren und zugehörigen Grenzflächendaten den zugehörigen ebenen Flächenabschnitt zuzuordnen.

12. Analysesoftware für die Gebäudebewirtschaftung, welche, wenn sie auf einem Prozessor ausgeführt wird Grenzflächendaten zu einen Raum begrenzenden Grenzflächen zusammen mit Daten zum Aufbau, die durch Aufbringen von elektromagnetischen Wellen auf die Grenzfläche und Empfangen der reflektierten Wellen ermittelt werden, in einem Speicher abgelegt und dort zur weiteren Bearbeitung bereitgestellt werden, wobei die Grenzflächendaten die den Raum begrenzenden Grenzflächen hinsichtlich ihrer räumlichen Ausdehnung definieren und die Daten zum Aufbau Details zum inneren Aufbau hinter der Grenzfläche angeben, **dadurch gekennzeichnet, dass** die Bewegungen eines Radarwellen auf die Grenzfläche aufbringenden Messgerätes auf Basis der Daten zum Aufbau so gesteuert werden, dass bei Erkennen einer Unstetigkeit im Aufbau eine Datendichte im Bereich der Unstetigkeit durch Verlangsamen der Bewegungen des Messgeräts erhöht wird.

13. Datenträger enthaltend eine Analysesoftware nach Anspruch 12.

## Claims

1. Analysis method for building management and administration, in which boundary surface data for boundary surfaces bounding a space, together with data for the structure, which are determined by applying electromagnetic waves to the boundary surface and receiving the reflected waves, are stored in a memory and prepared for display, wherein the boundary surface data define the boundary surfaces bounding the space with respect to their spatial extent and the data for the structure provide details of the internal structure behind the boundary surface, **characterized in that** the movements of a measuring device applying radar waves to the boundary surface are controlled on the basis of the data for the structure in such a way that, when a discontinuity in the structure is detected, a data density in the region of the discontinuity is increased by slowing down the movements of the measuring device.

2. Analysis method according to claim 1, **characterized in that** the boundary surface data are obtained by an imaging and/or laser measuring method.

3. Analysis method according to one of the previous claims, **characterized in that** at discrete points of the boundary surface, the data for the structure are determined by applying radar waves to the boundary surfaces and receiving the reflected waves, and are stored assigned to position data of the discrete points of the boundary surface.

4. Analysis method according to one of the previous claims, **characterized in that** the position and dimension of layers located behind the boundary surface are determined on the basis of a reflection pattern of the reflected waves.

5. Analysis method according to claim 4, **characterized by** a geometric calibration of the reflection pattern on the basis of boundary surface data.

6. Analysis method according to one of the previous claims, **characterized in that** the frequency of the waves radiated onto the boundary surface is varied to analyze the materials behind the boundary surface.

7. Analysis method according to claim 6, **characterized in that** the material properties of layers behind the boundary surface are inferred from the material-dependent permittivity.

8. Analysis method according to claim 7, **characterized in that** the data on the reflection pattern are compared with stored reflection data on the reflection behaviour of certain building materials in order to draw conclusions about the material composition of one of the layers behind the boundary surface, and that a specific building material is assigned to the layer.

9. Analysis method according to claim 8, **characterized in that** if the comparison does not lead to any agreement, the non-assignable building material of a layer is optionally classified in a property class and/or an input window is opened in a display device of a data processing device carrying out the method for the layer which cannot be determined materially, which allows the input of an input value for the corresponding layer.

10. Analysis method according to one of the previous claims, **characterized in that** an input window is opened in a display device of a data processing device carrying out the method, which allows the input of a property value determinable from the outside of the boundary surface.

11. Analysis method according to one of the previous claims, **characterized in that** the interface data are analyzed in order to identify planar surface sections of the interfaces bounding the space and to assign the associated planar surface section to associated interface data.

12. Analysis software for building management, which, when executed on a processor, stores interface data for interfaces bounding a space, together with data for the structure, which data are determined by applying electromagnetic waves to the interface and receiving the reflected waves, in a memory, where they are provided for further processing, the interface data defining the interfaces bounding the space with respect to their spatial extent and the data for the structure provide details of the internal structure behind the boundary surface, **characterized in that** the movements of a measuring device applying radar waves to the boundary surface are controlled on the basis of the data for the structure in such a way that, when a discontinuity in the structure is detected, a data density in the region of the discontinuity is increased by slowing down the movements of the measuring device.

13. Data carrier containing an analysis software according to claim 12.

## Revendications

1. Procédé d'analyse pour la gestion ou l'administration de bâtiments, lors duquel des données d'interface concernant des interfaces délimitant un espace sont stockées dans une mémoire avec des données de structure déterminées par application d'ondes électromagnétiques sur l'interface et réception des ondes réfléchies, et sont préparées en vue de leur affichage, dans lequel les données d'interface définissent les interfaces délimitant l'espace en ce qui concerne leur étendue spatiale et les données de structure fournissent des détails sur la structure interne située derrière l'interface, **caractérisé en ce que** les déplacements d'un appareil de mesure appliquant des ondes radar sur l'interface sont commandés en se basant sur les données de structure de sorte que, lors de la détection d'une discontinuité dans la structure, une densité de données dans la région de la discontinuité est augmentée grâce à un ralentissement des déplacements de l'appareil de mesure.

2. Procédé d'analyse selon la revendication 1, **caractérisé en ce que** les données d'interface sont obtenues grâce à un procédé d'imagerie et/ou de mesure au laser.

3. Procédé d'analyse selon l'une quelconque des revendications précédentes, **caractérisé en ce que** les données de structure sont déterminées au niveau d'emplacements discrets de l'interface par application d'ondes radar sur les interfaces et réception des ondes réfléchies, et sont stockées en étant associées à des données de position des emplacements discrets de l'interface.

4. Procédé d'analyse selon l'une quelconque des revendications précédentes, **caractérisé en ce que** la position et la dimension de couches situées derrière l'interface sont déterminées en se basant sur un motif de réflexion des ondes réfléchies.

5. Procédé d'analyse selon la revendication 4, **caractérisé par** un calibrage géométrique du motif de réflexion en se basant sur des données d'interface.

6. Procédé d'analyse selon l'une quelconque des revendications précédentes, **caractérisé en ce que** la fréquence des ondes rayonnées sur l'interface est variée afin d'analyser les matériaux situés derrière l'interface.

7. Procédé d'analyse selon la revendication 6, **caractérisé en ce que** la permittivité propre à chaque matériau permet de conclure sur la nature matérielle des couches situées derrière l'interface.

8. Procédé d'analyse selon la revendication 7, **caractérisé en ce que** les données concernant le motif de réflexion sont comparées à des données de réflexion stockées concernant le comportement de réflexion de certains matériaux de construction afin de conclure à la nature matérielle d'une des couches situées derrière l'interface, et **en ce qu'**un matériau de construction spécifique est associé à la couche.

9. Procédé d'analyse selon la revendication 8, **caractérisé en ce que,** si la comparaison n'aboutit à aucune concordance, le matériau non-associable d'une couche est classée dans une classe de propriété et/ou une fenêtre de saisie concernant la couche dont la nature ne peut être déterminée est ouverte dans un dispositif d'affichage d'un dispositif de traitement de données mettant en oeuvre le procédé, ladite fenêtre permettant la saisie d'une valeur de saisie pour la couche correspondante.

10. Procédé d'analyse selon l'une quelconque des revendications précédentes, **caractérisé en ce qu'**une fenêtre de saisie est ouverte dans un dispositif d'affichage d'un dispositif de traitement de données mettant en oeuvre le procédé, ladite fenêtre permettant la saisie d'une valeur de propriété pouvant être déterminée depuis l'extérieur de l'interface.

11. Procédé d'analyse selon l'une quelconque des revendications précédentes, **caractérisé en ce que** les données d'interface sont analysées afin d'identifier des sections de surface planes des interfaces délimitant l'espace et d'associer des données d'interface spécifiques à la section de surface plane spécifique.

12. Logiciel d'analyse destiné à la gestion de bâtiments, qui, lorsqu'il est exécuté sur un processeur, stocke dans une mémoire des données d'interface concernant des interfaces délimitant un espace et des données de structure déterminées par application d'ondes électromagnétiques sur l'interface et réception des ondes réfléchies, et les met à disposition en vue d'un traitement ultérieur, dans lequel les données d'interface définissent les interfaces délimitant l'espace en ce qui concerne leur étendue spatiale et les données de structure fournissent des détails sur la structure interne située derrière l'interface, **caractérisé en ce que** les déplacements d'un appareil de mesure appliquant des ondes radar sur l'interface sont commandés en se basant sur les données de structure de sorte que, lors de la détection d'une discontinuité dans la structure, une densité de données dans la région de la discontinuité est augmentée grâce à un ralentissement des déplacements de l'appareil de mesure.

13. Support de données contenant un logiciel d'analyse selon la revendication 12.
